# EUROPEAN PATENT APPLICATION

(11) **EP 4 277 045 A1**
(43) Date of publication of application: **15.11.2023**
(21) Application number: 23172060.8
(22) Date of filing: 08.05.2023
(51) Int. Cl.: H01R 13/641, H01R 13/703

(54) **ELECTRICAL CONNECTOR FOR A SAFETY RESTRAINT SYSTEM AND A TESTING METHOD THEREOF**

(30) Priority: 09.05.2022 FR 2204369
(71) Applicant: Tyco Electronics France SAS, 95300 Pontoise (FR)
(72) Inventor: Delestre, Quentin, 95300 Pontoise (FR); Lord, Steven, 95300 Pontoise (FR); Rouillard, Xavier, 95300 Pontoise (FR)
(74) Representative: Grünecker Patent- und Rechtsanwälte PartG mbB

(57) **Abstract**

The invention relates to an electrical connector (100) a for a safety restraint system of a motor vehicle, in particular a squib-type connector for an airbag system, configured to be mated along a mating direction (x) with a mating electrical connector, comprising a housing (1), two electrical terminals (23a), a shunt (27) for a short-circuiting of the two terminals (23a), and a connector position assurance (CPA) device (3) for assuring the mating of the connector (100) with the mating connector. The connector is characterized in that the shunt bridge (29) and the linking portions of the shunt arms (33a) are fit in the housing (1), each one of the contact portions (35a) is resiliently engaged with its respective electrical terminal (23a), and the contact portion (35a) of at least one of the two shunt arms (33a) is configured to be displaced by the CPA device (3) when the CPA device (3) is moved into the final position.

## Description

The present invention relates to an electrical connector for a safety restraint system of a motor vehicle, in particular a squib-type connector for an airbag system. The invention also relates to a testing method for the electrical connector.

Electrical connectors for safety restraint systems are known in the art to comprise two electrical terminals housed in a housing, the electrical terminals being configured to be attached, for example crimped, to electrical conductors of an electrical cable. The electrical connectors typically comprise connector position assurance (CPA) devices, which are moveably arranged in the housing from an unlocked position, also called delivery position or initial position, to a locked position, also called final position or mated position. CPA devices have the purpose to securely lock electrical connectors when mated with mating electrical connectors. The CPA devices can also prevent the electrical connectors from being mated with or unmated from mating electrical connectors in a wrong or inadvertent way.

For example, in safety restraint systems, an electrical connector can be a squib-type connector configured to be mated to an electrical connector of an airbag system, and can in a trigger event convey an electrical signal to the airbag system to activate a squib charge. The CPA device thus performs the critical function of ensuring the safe operation of the electrical connection.

It is also known to provide the electrical terminals of the electrical connector with an integrated shunt device which, when the CPA device is in an unlocked position, short-circuits the two electrical terminals. The shunt device thus prevents an unintended electrical signal from being conveyed to a mating electrical connector, for example in the moment of the mating of the electrical connector with a mating electrical, or during an initial stage of a cabling installation.

In this configuration, the CPA device, when moved from an unlocked to a locked position, mechanically displaces at least one component of the shunt device, also lifts the short-circuiting of the electrical terminals. When the CPA device is in a locked position, electrical signals can be conveyed to the mating electrical connector in an unimpeded way and the electrical connection is rendered safe for operation. The shunting function of the shunt device is critical during the installation of the connectors, but typically of lesser importance during the majority of the lifetime of the connector. The CPA device therefore fulfils in this configuration the additional function of lifting the short-circuiting of a shunt device integrated in the connector.

However, integrating a shunt device in the electrical terminals increases the complexity and production cost of the electrical terminals. In particular, the electrical terminals require high reliability and durability, and are thus manufactured in expensive materials, for example particularly corrosion-resistant and conductive materials. Manufacturing an integrated shunt device in one piece with the electrical terminals in the same material therefore represents an additional cost burden.

Further, the testing of the electrical conductivity of the electrical connector, for example in the context of routine testing by a harness maker, requires several steps, which can be inconvenient. In particular, the CPA device may have to be artificially moved into a locked position by means of a dedicated counterpart in order to lift the short-circuiting, and then to be moved back into the unlocked position by means of another dedicated counterpart for final installation.

In view of the above, it is an object of the present invention to provide an improved electrical connector for a safety restraint system, which remedies to at least one of the above-indicated problems.

This object is achieved with an electrical connector for a safety restraint system of a motor vehicle, in particular a squib-type connector for an airbag system, configured to be mated along a mating direction with a mating electrical connector. The connector comprises a housing, the housing having a first extremity and a second extremity, the second extremity extending in the mating direction, and two electrical terminals, each terminal traversing the housing from the first extremity to the second extremity. The connector further comprises a shunt for a short-circuiting of the two terminals, the shunt comprising two shunt arms, each shunt arm having a contact portion and a linking portion, and a shunt bridge linking the linking portions of the shunt arms, and a connector position assurance (CPA) device for assuring the mating of the connector with the mating connector, wherein the CPA device is moveably arranged in the housing between a delivery position and a final position, and wherein the CPA device is configured to lift the short-circuiting of the terminals. The electrical connector is characterized in that the shunt bridge and the linking portions of the shunt arms are fit in the housing, each one of the contact portions is resiliently engaged with its respective electrical terminal, and the contact portion of at least one of the two shunt arms is configured to be displaced by the CPA device when the CPA device is moved into the final position.

The electrical connector according to the invention provides a shunt that is separate from the electrical terminals. This is advantageous as it allows the shunt to be produced in a different, in particular a more suitable and less cost-intensive, material, to be suited to the limited use of the shunt. At the same time, the electrical terminals are less structurally complex and materially voluminous, reducing their production costs. In an additional advantage, a CPA device engaging with the shunt during the locking movement to lift the short-circuiting no longer engages with parts of electrical terminals, thus further increasing the durability of the terminals.

The electrical connector according to the invention also provides for a faster and less straining testing procedure. Indeed, by providing the shunt with contact portions that are, when the CPA is in an unlocked position, resiliently engaged with the electrical terminals, said contact portions can be displaced and the short-circuiting lifted without touching the electrical terminals. Thus, the durability of the electrical terminals can be further increased. In addition, as the shunt is separate from the electrical terminals, it is easier to provide an external mechanical actuation to displace the shunt and lift the short-circuiting, without having to move the CPA device to a locked position.

In one aspect of the invention, the at least one contact portion can extend at least partially in the mating direction and can comprise a cantilever protrusion protruding from the contact portion in a second direction different to the mating direction, in particular a second direction orthogonal to the mating direction.

By providing such a cantilever protrusion, the displacement of the contact portion when engaged with an electrical terminal, can be facilitated due to the presence of an additional surface. For example, an external mechanical actuation can be provided to move the contact portion in a desired direction away from the engagement, thus lifting the short-circuiting of the terminals. In particular, the lifting can be realized with a reduced risk of damaging engagement surfaces of the shunt or the electrical terminals.

In one aspect, the cantilever protrusion can protrude from a distal extremity of a contact portion of the shunt arm.

At the distal extremity, the mechanical actuation force needed to displace the contact portion away from an engagement is reduced to the longer level arm.

In one aspect, the cantilever protrusion can protrude towards the other contact portion, such that the cantilever protrusion is located between the two shunt arms.

In this configuration, the external mechanical actuation can be provided in between the two shunt arms, that is, in between or in close proximity to the electrical terminals. Therefore, the testing equipement needed to displace a contact portion can be more compact.

In one aspect, the cantilever protrusion can comprise a first surface portion and a second surface portion, the first and second surface portion being arranged at an angle with respect to each other.

In this aspect, when the cantilever protrusion is subjected to a displacement force, the displacement direction of the contact portion can be more accurately oriented. This further reduces the risk of damage of sensitive portions of the shunt or the electrical terminals.

In one aspect, at least one contact portion can comprise a bulged contact surface configured to engage a respective surface of an electrical terminal.

This bulged contact portion allows for the engagement between the shunt and the electrical terminal to be softened, thus increasing reliability, durability and reducing contact resistance.

In one aspect, the bulged contact surface can be plated with a noble metal, preferably gold.

This reduces the contact resistance.

In one aspect, the shunt bridge and the linking portions of the shunt arms can be fit in the housing by means of a form fit and/or a friction fit.

This allows are more rigid fitting of the shunt in the connector housing. A friction fit of the shunt in the housing may provide a particularly cost-efficient production and simple assembly.

In one aspect, the connector can comprise an elongated space extending from an opening at the second extremity of the housing to the cantilever protrusion of the shunt.

This configuration allows for a pin to be inserted in the housing to provide the external mechanical actuation for the displacement of the contact portion, for example to lift the short-circuiting by the shunt during testing, without moving the CPA in a locked position.

An object of the invention is also achieved with a testing method for the testing of an electrical connector according to one of the above-described aspects comprising the steps of:
i. Arranging the CPA device in the housing of the connector in the delivery position,
ii. Placing the connector on a testing counterpart configured to measure an electrical signal between the two electrical terminals,
iii. Actuating a testing pin of the testing counterpart to displace the at least one contact portion of a shunt arm, such that the short-circuiting of the terminals is lifted, and
iv. Measuring the electrical signal between the two electrical terminals

This testing method allows for the electrical signalling of the connector to be ascertained and confirmed in a faster and more convenient way. In particular, it is no longer necessary to provide dedicated testing equipement to artifically lock and unlock the CPA device, in order to obtain a temporary lifting of the short-circuit prior to final installation.

These, as well as other objects and advantages of this invention will be more completely understood and appreciated by careful study of the following more detailed description of the presently preferred exemplary embodiment of the invention, taken in conjunction with accompanying drawings, in which:
[Fig. 1A] displays a perspective view of an electrical connector according to an embodiment of the invention, wherein the CPA device is in an unlocked position.
[Fig. 1B] displays the same view of the connector of Figure 1A, wherein the CPA device is in a locked position.
[Fig. 2A] displays a cross-sectional view along the axis A of the connector for Figure 1A, including an enlarged view of a shunt engagement zone with the terminals.
[Fig. 2B] displays the view of the Figure 2A, wherein the CPA device is in a locked position, as shown in Figure 1B.
[Fig. 3] displays a three-dimensional perspective view of the CPA device of the first connector.
[Fig. 4] displays a three-dimensional perspective view of the shunt of the first connector.
[Fig. 5] displays a three-dimensional perspective view of the shunt and the electrical terminals, wherein the shunt is engaged with the electrical terminals.
[Fig. 6A] displays the electrical connector of the embodiment during a testing procedure.
[Fig. 6B] displays the electrical connector of the embodiment during a testing procedure.

### Description of Embodiments

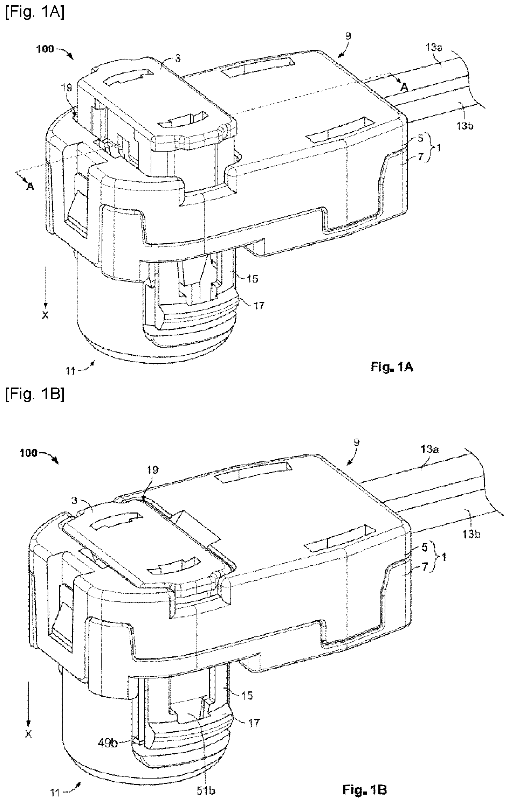

An embodiment of the electrical connector 100 of the invention is described with reference to the outside views shown in Figures 1A and 1B, which illustrate the locking function of the CPA device. The connector 100 in this embodiment is a squib-type connector for an airbag system and comprises a housing 1 and a connector position assurance (CPA) device 3. In this embodiment, the housing 1 comprises a top shell 5 and a lower shell 7 which are fit together by a form fit connection.

The housing has a first extremity 9 and a second extremity 11. The first extremity 9 is configured to receive two insulated electrical conductors, shown for illustrative purposes in references 13a, 13b. In this embodiment, the first extremity 9 and the electrical conductors 13a, 13b extend along a direction y orthogonal to the mating direction x. The second extremity 11 extends along the mating direction x and is configured to be received by a mating electrical connector and establishing a mating connection therewith. In this embodiment, the connector has an L-shape and is a 90°-exit-type connector. Other shapes, such as an elongated shape in a 180°-exit type connector are, however, also possible.

The second extremity 11 comprises a latching tongue 15 comprising a latching lip 17. The latching tongue 15 extends in mating direction x and is resiliently attached on one side along the mating direction x to the lower shell 7. The latching lip 17 protrudes radially outwards from a portion of the latching tongue 15. It is understood that similar or identical latching tongue may be provided on the other side of the connector 100.

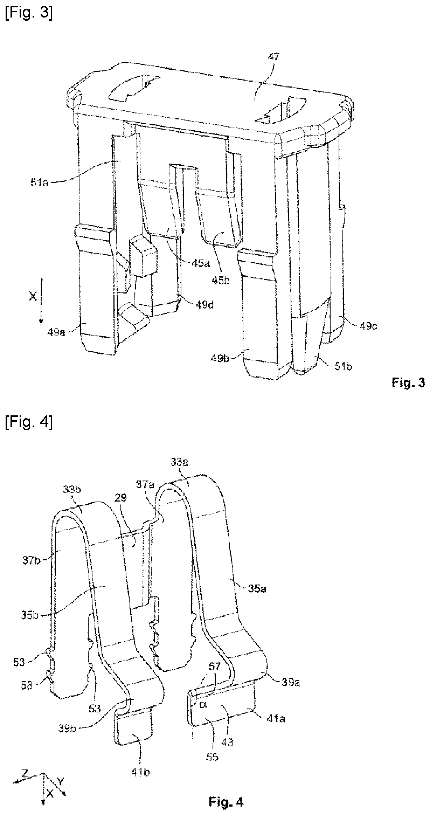

The CPA device 3 is received in the housing 1 through a traversing hole 19 in the top shell 5 of the housing 1. The structure of the CPA device 3 will be described more in detail in the following section in reference to Figure 3.

In Figure 1A, the CPA device 3 is positioned in the connector 100 in an unlocked position. In the unlocked position, the CPA device 3 is not fully inserted in the housing 1 through the traversing hole 19. Instead, in the unlocked position, the CPA device 3 is only partially inserted in the housing 1 and partially protrudes towards the outside of the top shell 5. Therefore, the CPA device 3 can be manually moved into the locked position by a push into the mating direction x. Further, in this unlocked position, the latching tongue 15 of the housing 1 is manually or mechanically displaceable in a direction z orthogonal to the mating direction x, by virtue of the resilient attachment at its one end.

In Figure 1B, the CPA device 3 has been moved by a push in a locked position in the connector 100. In the locked position, the CPA device 3 is fully inserted in the housing 1 through the traversing hole. The CPA device 3 in the locked position no longer protrudes towards the outside of the top shell 5. Here, the connector 100 is shown with the CPA device 3 in locked position without the presence of the mating electrical connector. In practical use, the CPA device 3 can, however, only be moved into the locked position when the connector 100 is mated with a mating electrical connector.

In this position, the latching tongue 15 is blocked by the blocking arm 51a and by the guiding arms 49b, 49c (49c visible only on Figure 3) of the CPA device 3. The blocking arm 51a prevents the latching tongue 15 from being physically displaced towards the inside of the housing 1. Thus locking the connector 100 with a mating electrical connector which is not shown but which is known in the art.

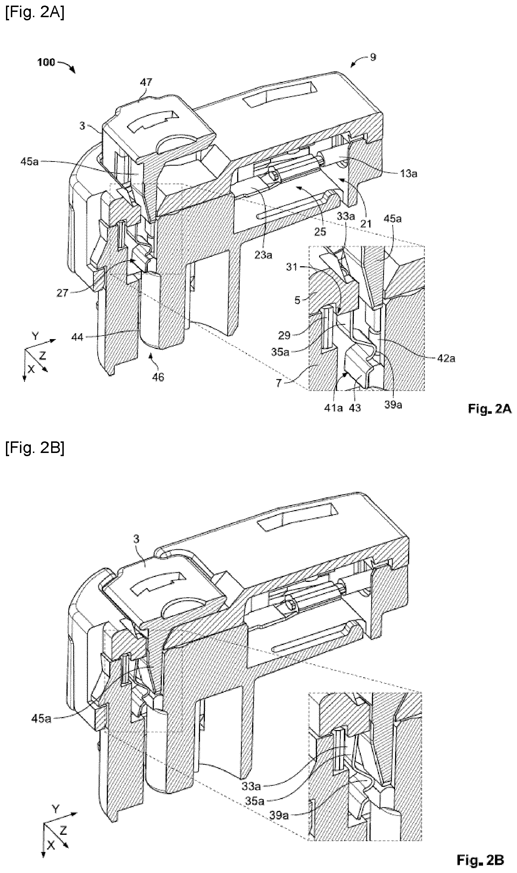

The interior structure of the connector 100 is now described with reference to Figures 2A and 2B, displaying a three-dimensional cross-sectional view of the connector, which illustrate the short-circuit lifting function of the CPA device 3.

Figures 2A and 2B display cross-sections along a cross-sectional plane A as shown in the unlocked conncetor of Figure 1A, the plane A corresponding to an x-y plane through the middle of the connector 100. It is understood that in this embodiment, the connector 100 is broadly symmetrical about the plane A and corresponding features can be found on the non-visible side of the connector 100.

Figure 2A shows a primary junction space 21 formed in the first extremity 9 of the connector 100. In the primary junction space 21, a junction portion 25 of a first electrical terminal 23a is arranged extending along the first extremity 9 in the direction y orthogonal to the mating direction x. For illustrative purposes, the junction portion 25 is shown in Figure 2A to be crimped on an insulation-stripped part of the electrical conductor 13a.

A shunt 27 is disposed in the housing 1. The shunt 27 comprises a shunt bridge 29 which is sandwiched in the x-z plane between the lower shell 7 and the upper shell and extends along an inner surface of the lower shell 7 of the housing 1. The shunt bridge 29 is locked by form fit to the housing 1 by a blocking ridge 31 formed on the top shell 5.

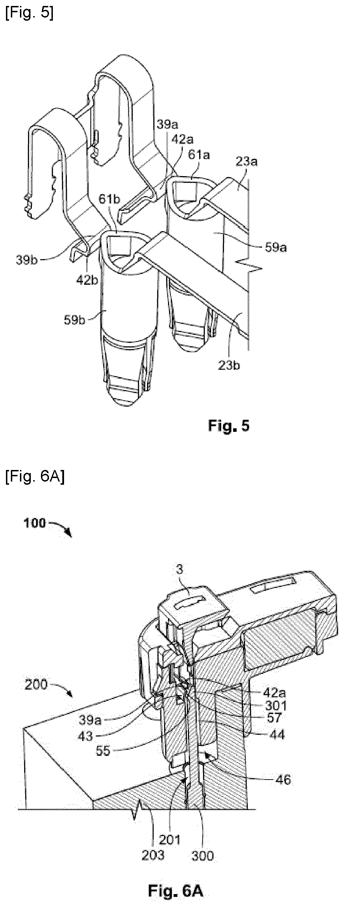

The structure of the shunt 27 and of the electrical terminals 23a, 23b will be described in more detail in the following sections in reference to Figures 4 and 5.

Figure 2A illustrates that the shunt 27 comprises a first shunt arm 33a with a contact portion 35a. A first linking portion 37a linking the first shunt arm 33a to the shunt bridge 29 is not visible on Figure 2A but is illustrated in Figures 4 and 5 and will be further described there.

The contact portion 35a extends at least partially in the mating direction x and comprises a bulged contact surface 39a, and a distal extremity 41a in mating direction x. The bulged contact surface 39a of the shunt arm 33a protrudes in the y direction perpendicular to the mating direction x to engage with a shunting surface 42a of the electrical terminal 23a.

On the corresponding side not visible of Figure 2A, bulged contact surface 39b, as shown in Figure 4, is engaged with the shunting surface 42b, as shown in Figure 5. Thus, the shunt 27 establishes a short-circuiting of the electrical terminals 23a, 23b.

The distal extremity 41a of the contact portion 35a of the shunt arm 33a comprises a cantilever protrusion 43 extending in the mating direction x and protruding in a direction z orthogonal to the mating direction x from the contact portion 35a. The features and functions of the cantilever protrusion 43 will be described in following sections.

The lower shell 7 of the housing 1 comprises an elongated space 44 extending from an opening 46 at the second extremity 11 inside the housing 1 so that the cantilever protrusion 43 of the shunt 27 gets accessible form the outside.

Figure 2A further shows a first displacement prong 45a of the CPA device 3, which protrudes orthogonally from a main body 47 of the CPA device in the mating direction x. In the unlocked position shown in Figure 2A, the CPA device 3 is not fully inserted in the traversing hole 19 of the top shell 5. The displacement prong 45a is not in contact with the bulged contact surface 39a of the shunt 27 and the contact portion 35a therefore is at rest, thus engaged with the shunting surface 42a.

Figure 2B shows the view of Figure 2A, wherein the CPA device 3 has been moved from the unlocked position into the locked position. In this position, the prong 45a has moved in the mating direction x and displaced the contact portion 35a in a direction opposed to the direction y. Thus, the prong 45a separates the engagement of the bulged contact surface 39a of the shunt arm 33a with the shunting surface 42a, hidden by the prong 45a in Figure 2B, and the short-circuiting of the electrical terminals 23a, 23b by the shunt 27 has been lifted. The CPA device 3 displaced only the shunt 27 and not the electrical terminals 23a, 23b.This can increase the durability of the electrical contacts.

Figure 3 is a three-dimensional perspective view of the CPA device 3. The CPA device 3 comprises a main body 47 and two displacement prongs 45a, 45b protruding orthogonally from the main body 47 in the mating direction x. The CPA device 3 further comprises four guiding arms 49a, 49b, 49c, 49d at each corner of the main body 47 to guide the CPA device 3 inside the housing 1 of the connector 100. The CPA device 3 further comprises two blocking arms 51a, 51b to secure the connexion between the connector 100 and its mating connector.

Figure 4 is a three-dimensional perspective view of the shunt 27 with the two shunt arms 33a 33b and the shunt bridge 29. The shunt arms 33a 33b comprise linking portions 37a, 37b and contact portions 35a, 35b. The shunt bridge 29 links the linking portions 37a, 37b on the shunt arms 33a, 33b. The linking portions 37a, 37b extend further beyond the shunt bridge where they further comprise hooks 53 to establish a form fit connection with corresponding recesses in the lower shell 7 of the housing 1 for the connection 100.

The contact portions 35a, 35b extend at least partially in the mating direction x and comprise the bulged contact surfaces 39a, 39b, which can be plated with a noble metal, in particular gold.

The use of a noble metal reduces the contact resistance and increases the corrosion resistance of the contact with the shunting surfaces 42a, 42b.

A cantilever protrusion 43 protrudes from the distal extremity 41a of the contact portion 35a in a direction z orthogonal to the mating direction x. In this embodiment, the cantilever protrusion 43 protrudes towards the distal extremity 41b of the other contact portion 35b, such that the cantilever protrusion 43 is located in between the two shunt arms 33a, 33b.

The cantilever protrusion 43 has a first surface portion 55 and a second surface portion 57. Preferably, the first surface portion 55 of the cantilever protrusion 43 is parallel to the extension direction of the elongated space 44. That is, in this embodiment, the first surface portion is arranged parallelly to the mating direction x. Alternatively or in addition, the first surface portion 55 can be arranged orthogonally to the engagement of the bulged contact surface 39a with the shunting surface 42a. That is, the first surface portion 55 can be arranged parallelly to the x-z plane.

The first and second surface portions 55, 57 are arranged at an angle α with respect to each other, α being the acute angle between the two surface portions 55, 57. The angle α has an angular value of more than 90° and less than 180°. For example, in this embodiment, the angle α has an angular value comprised between 130° to 150°.

The shunt 29 is preferably a single body in an electrically conductive material. Therefore, the shunt 29 is able to short-circuit the electrical circuit between the bulged contacts surfaces 39a, 39b. In addition, the shunt can be manufactured in a different material from the terminals 23a, 23b, in particular a material less noble for the limited use of the shunt, for example copper or aluminium.

The contact portions 35a, 35b form springs together with the linking portions 37a, 37b, when they are fitted in the housing 1. Therefore, the contact portions 35a, 35b can be displaced, in particular along a direction y orthogonal to the mating direction x, when they are mechanically actuated, for example by a testing pin or the CPA device 3 inserted along the elongated space 44.

Figure 5 is a three-dimensional perspective view of the shunt 27 and the electrical terminals 23a, 23b and represents their respective positioning in an unlocked position of the CPA device 3. Figure 5 shows mating portions 59a, 59b of the electrical terminals 23a, 23b which extend inside the second extremity 11 of the housing 1 along the mating direction x. The mating portions 59a, 59b are configured to receive mating pins of the mating electrical connector. The electrical terminals 23a, 23b thus form an L-shape traversing the housing 1 from the first extremity 9 to the second extremity 11.

The mating portions 59a, 59b of the electrical terminals 23a, 23b comprise juts 61a, 61b protruding in the direction opposed to the direction y. The juts 61a, 61b present outwardly the shunting surfaces 42a, 42b, which are engaged with the respective bulged contact surfaces 39a, 39b of the shunt so that the short circuit is established.

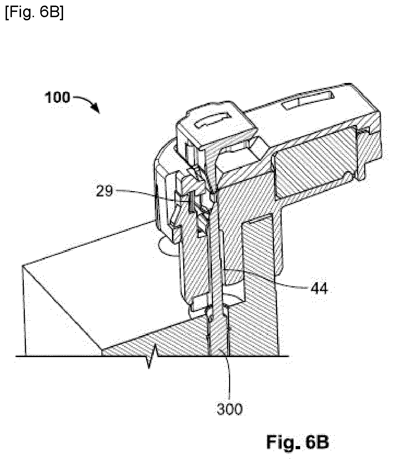

Figures 6A and 6B display the electrical connector 100 during a testing procedure in which an electrical testing signal used to check the performance of the connector is ascertained. In Figure 6A, the connector 100 is in the unlocked position and the CPA device 3 is not fully pushed inside the housing 1.

The connector 100 is mounted on a testing counterpart 200 capable of measuring an electrical signal between the electrical terminals 23a, 23b, not visible in Figure 6A but illustrated in Figure 5. The testing counterpart 200 comprises a passageway 201 extending along the mating direction x through a baseplate 203 of the testing counterpart 200. A testing pin 300, made of an electrical isolating material, is inserted through the passageway 201 of the counterpart 200 and through the opening 46 in the housing 1 into the elongated space 44.

In Figure 6A, the testing pin 300 is partially inserted, and the bulged contact surface 39a just starts to be disengaged from the shunting surface 42a, as the tip 301 of the pin 300 has engaged with the cantilever protrusion 43, along the cantilever surfaces 55 and 57.

In Figure 6B, the testing pin 300 has been fully inserted into the connector 100 through the elongated space 44 and the tip 301 of the pin 300 now fully isolates the shunt 29 from the terminals 23a, 23b. The testing pin 300 is sufficiently thin to only interact with the cantilever surface 55 and/or 57 but does not touch the bulged surface 39a with its plating.

The provision of a separate shunt 29 in the housing 1, and the positioning of the cantilever protrusion 43 as described above allows for a convenient and safe external actuation a shunt arm. In particular, the displacement of the contact portion when engaged with an electrical terminal can be facilitated. The external mechanical actuation by the testing pin 300 moves the contact portion 35a in a desired direction away from the engagement, thus lifting the short-circuiting of the terminals 23a, 23b, without risk of damage to or modification of the connector 100. The testing pin 300 only interacts with the cantilever protrusion 43 so that noble metal plated part of the shunt cannot get damaged. As a result, the electrical connector 100 can be tested quickly, without having the repeatedly move the CPA device 3 from one position to another and without having to connect the connector 100 with a mating connector device.

### Reference numerals

1 housing
3 CPA device
5 top shell
7 lower shell
9 first extremity of the housing
11 second extremity of the housing
13a, 13b insulated electrical conductors
15 latching tongue
17 latching protrusion
19 traversing hole in the top shell
21 primary junction space
23a , 23b electrical terminals
25 junction portion of the electrical terminal 23a
27 shunt
29 shunt bridge
31 blocking ridge formed on the top shell
33a, 33b shunt arms of the shunt
35a, 35b contact portions of the shunt arms of the shunt
37a, 37b linking portions of the shunt arms of the shunt
39a, 39b bulged contact surfaces
41a, 41b distal extremities of the contact portions of the shunt arms
42a, 42b shunting surfaces of the electrical terminals 43 cantilever protrusion
44 elongated space in the housing
45a displacement prongs of the CPA device
46 opening in the second extremity
47 main body of the CPA device
49a, 49b, 49c, 49d guiding arms of the CPA device
51a, 51b blocking arms of the CPA device
53 hooks of the linking portions
55 first surface portion of the cantilever protrusion
57 second surface portion of the cantilever protrusion
59a, 59b mating portions of the electrical terminals
61a, 61b juts of the electrical terminals
100 electrical connector
200 testing counterpart
201 passageway in the counterpart
203 baseplate of the counterpart
300 testing pin
301 tip of the testing pin
x mating direction
y, z directions orthogonal to the mating direction
α angle of arrangement of first and second surfaces of the cantilever protrusion

## Claims

1. Electrical connector for a safety restraint system of a motor vehicle, in particular a squib-type connector for an airbag system, configured to be mated along a mating direction (x) with a mating electrical connector, comprising
a housing (1), the housing (1) having a first extremity (9) and a second extremity (11), the second extremity (11) extending in the mating direction (x),
two electrical terminals (23a, 23b), each terminal (23a, 23b) traversing the housing (1) from the first extremity (9) to the second extremity (11),
a shunt (27) for a short-circuiting of the two terminals (23a, 23b), the shunt (27) comprising two shunt arms (33a, 33b), each shunt arm (33a, 33b) having a contact portion (35a, 35b) and a linking portion (37a,37b), and a shunt bridge (29) linking the linking portions (37a,37b) of the shunt arms (33a, 33b), and
a connector position assurance (CPA) device (3) for assuring the mating of the connector (100) with the mating connector, wherein the CPA device (3) is moveably arranged in the housing (1) between unlocked position and a locked position, and wherein the CPA device (3) is configured to lift the short-circuiting of the terminals (23a, 23b),
**characterized in that**
the shunt bridge (29) and the linking portions (37a, 37b) of the shunt arms (33a, 33b) are fit in the housing (1),
each one of the contact portions (35a, 35b) is resiliently engaged with its respective electrical terminal (23a, 23b), and
the contact portion (35a, 35b) of at least one of the two shunt arms (33a, 33b) is configured to be displaced by the CPA device (3) when the CPA device (3) is moved into the locked position.

2. Electrical connector according to claim 1, wherein the at least one contact portion (35a, 35b) extends at least partially in the mating direction (x) and comprises a cantilever protrusion (43) protruding from the contact portion (35a) in a second direction (z), in particular a second direction (z) orthogonal to the mating direction (x).

3. Electrical connector according to claim 2, wherein the cantilever protrusion (43) protrudes from a distal extremity (41a) of a contact portion (35a) of the shunt arm (33a).

4. Electrical connector according to claim 2 or claim 3, wherein the cantilever protrusion (43) protrudes towards the other contact portion (35b), such that the cantilever protrusion (43) is located between the two shunt arms (33a, 33b).

5. Electrical connector according to any one of claims 2 to 4, wherein the cantilever protrusion (43) comprises a first surface portion (55) and a second surface portion (57), the first (55) and second surface portion (57) being arranged at an angle (α) with respect to each other.

6. Electrical connector according to any one of claims 1 to 5, wherein at least one contact portion (35a, 35b) comprises a bulged contact surface (39a, 39b) configured to engage a respective surface (42a, 42b) of an electrical terminal (23a, 23b).

7. Electrical connector according to claim 6, wherein the bulged contact surface is plated with a noble metal, preferably gold.

8. Electrical connector according to any one of claims 1 to 7, wherein the shunt bridge (29) and the linking portions (37a, 37b) of the shunt arms (33a, 33b) are fit in the housing by means of a form fit and/or a friction fit.

9. Electrical connector according to any one of claims 1 to 8 in combination with claim 2, wherein the connector (100) comprises an elongated space (44) extending from an opening (46) at the second extremity (11) of the housing to the cantilever protrusion (43) of the shunt (27).

10. Testing method for the testing of an electrical connector (100) according to any one of claims 1 to 9, comprising the steps of:
i. Arranging the CPA device (3) in the housing (1) of the connector (100) in the unlocked position,
ii. Placing the connector (100) on a testing counterpart (200) configured to measure an electrical signal between the two electrical terminals (23a, 23b),
iii. Actuating a testing pin (300) of the testing counterpart (200) to displace the at least one contact portion (35a, 35b) of a shunt arm (33a, 33b), such that the short-circuiting of the terminals (23a, 23b) is lifted, and
iv. Measuring the electrical signal between the two electrical terminals (23a, 23b).
